# EUROPEAN PATENT SPECIFICATION

(11) **EP 0 719 442 B1**
(45) Date of publication and mention of the grant of the patent: **20.11.2002**
(21) Application number: 94928052.3
(22) Date of filing: 13.09.1994
(51) Int. Cl.: H01C 1/14, H01C 7/02

(54) **ELECTRICAL ASSEMBLY COMPRISING A PTC RESISTIVE ELEMENT**
ELEKTRISCHE BAUEINHEIT MIT EINEM PTC-WIDERSTANDSELEMENT
ENSEMBLE ELECTRIQUE COMPRENANT UN ELEMENT RESISTIF PRESENTANT UN COEFFICIENT DE TEMPERATURE POSITIF (CTP)

(30) Priority: 15.09.1993 US 121717
(43) Date of publication of application: 03.07.1996
(60) Divisional application: 02076768.7
(73) Proprietor: TYCO Electronics Corporation, Menlo Park, CA 94025-1164 (US)
(72) Inventor: FANG, Shou-Mean, Yokohama 236 (JP); SIDEN, Dennis, Portola Valley, CA 94028 (US); THOMPSON, Mark, San Carlos, CA 94070 (US); ZHANG, Michael, Hong Kong (HK)
(74) Representative: Jay, Anthony William
(86) International application number: US9410137
(87) International publication number: WO95008176

(56) References cited:
- EP-A- 0 223 404
- DE-A- 3 910 861
- DE-U- 8 716 103
- US-A- 3 775 725
- US-A- 4 486 737
- US-A- 4 924 074

## Description

This invention relates to electrical devices.

Many electrical devices comprise two laminar electrodes and, sandwiched between them, a laminar electrical element which may be a conductor, e.g. a resistive element, (as for example in a resistor or a varistor), or a non-conductor (as for example in a capacitor). Particularly useful devices of this type comprise a resistive element which exhibits PTC (positive temperature coefficient) behavior, in particular circuit protection devices which comprise two laminar electrodes and, sandwiched between the electrodes, a laminar resistive element which exhibits PTC behavior. The PTC resistive element may be composed of conductive polymer or a ceramic, e.g. a doped barium titanate. The term "conductive polymer" is used herein to denote a composition comprising a polymer and, dispersed (or otherwise distributed) therein, a particulate conductive filler.

In most such devices, an electrical lead is secured to each of the laminar electrodes, so that the device can be connected to other components of a circuit, e.g. mounted in apertures in a circuit board. The addition of leads is an additional expense and usually involves heating (e.g. during soldering or welding) which can cause damage (often manifested by a change in resistance), particularly to conductive polymer elements. The latter problem is particularly severe when a conductive polymer is heated a second time when the leads are connected to other circuit elements, in particular when the leads are connected to a printed circuit board by a soldering process. A further problem which can arise when such devices are to be mounted on a printed circuit board is that they protrude further from the board than is desirable.

US-A-4486737 discloses a low resistance ceramic PTC body having opposite poles, two opposite outer side surfaces being parallel to the longitudinal axis of the PTC body and two opposite end faces perpendicular to the outer side surfaces. The PTC body comprises rows of parallel depressions with partitions there between, the depressions having inner metallised surfaces at the opposite poles, metal layers disposed on the outer side surfaces, and metal strips disposed on the end faces interleaved in comb-fashion being connected to the metal layers.

We have now discovered, in accordance with the present invention, that in devices comprising a laminar electrical element between two electrodes, important advantages result from the presence of a transverse conductive member which passes through the electrical element and which is physically and electrically connected to one of the electrodes (the "first electrode"), but is not connected to the other electrode (the "second electrode"). The presence of such a transverse conductive member (often referred to herein as a "cross-conductor") makes it possible to make an electrical connection to the first electrode from the opposite side of the device. Furthermore, because the conductive member passes through the device, rather than around it, such devices can be made by processes in which the various operative steps are carried out on an assembly which corresponds to a plurality of devices and which, as the final step of the process, is divided into a plurality of devices. The ability to prepare devices in this way becomes increasingly important as the desired size (and, therefore, resistance) of the device decreases. This invention is, therefore, especially valuable for preparing devices which are to be mounted on circuit boards and in other situations in which the smaller the size and resistance of the device, the better. For example, this invention can be used to make circuit protection devices having a surface area of about 0.02 inch² (13 mm²⁾ or even less.

In one preferred aspect, this invention provides an electrical assembly which is defined by the features of claim 1.

This novel assembly can be
(i) an electrical device which is ready for connection (the first laminar conductive member then providing the first electrode, and the device including also a second electrode which is not electrically connected to the cross-conductor), or
(ii) a structure which (if necessary after further processing) can be divided into a plurality of electrical devices, each of the devices containing at least one cross-conductor.

In another preferred aspect, this invention provides an electrical assembly which comprises
(A) a printed circuit board including first and second conductive traces on a surface thereof, and
(B) an electrical device which comprises
   (1) a laminar PTC resistive element which (a) is composed of a resistive material which exhibits PTC behavior, and (b) has a first face and a second face;
   (2) a first laminar electrode which is secured to the first face of the PTC element;
   (3) a second laminar electrode which is secured to the second face of the PTC element;
   (4) an additional laminar conductive member which (a) is secured to the second face of the PTC element and (b) is spaced apart from the second electrode;
      the PTC element, the first electrode and the additional laminar conductive member defining an aperture which runs between the first electrode and the additional conductive member, through the PTC element; and
   (5) a transverse conductive member which (a) lies within the aperture, and (b) is physically and electrically connected to the first electrode and the additional conductive member;
said electrical device being placed on the printed circuit board and parallel thereto, with the first conductive trace physically and electrically connected to the additional conductive member, and the second conductive trace physically and electrically connected to the second electrode.

In another preferred aspect, this invention provides a method of making electrical devices which comprises
(A) providing an assembly which corresponds to a plurality of the electrical devices and which comprises
   (1) a laminar PTC resistive element which (i) is composed of a resistive material exhibiting PTC behavior, and (ii) has a first face and a second face,
   (2) a first laminar conductive member which is secured to the first face of the PTC element, and
   (3) a second laminar conductive member which is secured to the second face of the PTC element;
(B) making a plurality of apertures through the thickness of the assembly provided in step (A), the apertures being arranged in a regular pattern;
(C) simultaneously with step (B), or after step (B), placing a plurality of transverse conductive members within the apertures, in electrical contact with the first laminar conductive member;
(D) removing predetermined portions of at least one of the first and second conductive members; and
(E) after steps (A) to (D), dividing the assembly into a plurality of electrical devices, each device comprising (1) a part of the PTC resistive element, (2) a part of the first laminar conductive member, said part providing a first electrode in some of the devices and a second electrode in the other devices, (3) a part of the second laminar conductive member, said part providing a second electrode in some of the devices and a first electrode in the other devices, (4) a residual part of the second laminar conductive member, and (5) at least one transverse conductive member which electrically connects the residual part and the first electrode.

In this method, step (D) can be carried out before or after step (B) or before or after step (C).

This method preferably makes use of a multi-device assembly according to the invention and which is defined by the features of claim 8.

The invention is described below chiefly by reference to PTC circuit protection devices which comprise a laminar PTC element composed of a PTC conductive polymer and two laminar electrodes secured directly to the PTC element, and to the production of such devices. It is to be understood, however, that the description is also applicable, insofar as the context permits, to other electrical devices containing PTC conductive polymer elements, to electrical devices containing PTC ceramic elements, and to other electrical devices comprising two laminar electrodes with a laminar electrical element between them.

As described and claimed below, and as illustrated in the accompanying drawings, the present invention can make use of a number of particular features. Where such a feature is disclosed in a particular context or as part of a particular combination, it can also be used in other contexts and in other combinations, including for example other combinations of two or more such features.

### PTC Compositions

The PTC compositions used in the present invention are preferably conductive polymers which comprise a crystalline polymer component and, dispersed in the polymer component, a particulate filler component which comprises a conductive filler, e.g. carbon black or a metal. The filler component may also contain a non-conductive filler, which changes not only the electrical properties of the conductive polymer but also its physical properties. The composition can also contain one or more other components, e.g. an antioxidant, crosslinking agent, coupling agent or elastomer. For use in circuit protection devices, the PTC composition preferably has a resistivity at 23°C of less than 50 ohm-cm, particularly less than 10 ohm-cm, especially less than 5 ohm-cm. Suitable conductive polymers for use in this invention are disclosed for example in U.S. Patent Nos. 4,237,441, 4,304,987, 4,388,607, 4,514,620, 4,534,889, 4,545,926, 4,560,498, 4,591,700, 4,724,417, 4,774,024, 4,935,156, and 5,049,850.

The PTC resistive element is preferably a laminar element, and can be composed of one or more conductive polymer members, at least one of which is composed of a PTC material. When there is more than one conductive polymer member, the current preferably flows sequentially through the different compositions, as for example when each composition is in the form of a layer which extends across the whole device. When there is a single PTC composition, and the desired thickness of the PTC element is greater than that which can conveniently be prepared in a single step, a PTC element of the desired thickness can conveniently be prepared by joining together, eg. laminating by means of heat and pressure, two or more layers, eg. melt-extruded layers, of the PTC composition. When there is more than one PTC composition, the PTC element will usually be prepared by joining together, eg. laminating by means of heat and pressure, elements of the different compositions. For example, a PTC element can comprise two laminar elements composed of a first PTC composition and, sandwiched between them, a laminar element composed of a second PTC composition having a higher resistivity than the first.

When a PTC device is tripped, most of the voltage dropped over the device is normally dropped over a relatively small part of the device which is referred to as the hot line, hot plane or hot zone. In the devices of the invention, the PTC element can have one or more features which help the hot line to form at a desired location, usually spaced apart from both electrodes. Suitable features of this kind for use in the present invention are disclosed for example in U.S. Patents Nos. 4,317,027, 4,352,083, 4,907,340 and 4,924,072.

### Laminar Electrodes

Particularly useful devices of the invention comprise two metal foil electrodes, and a PTC conductive polymer element sandwiched between them, especially such devices which are used as circuit protection devices and have low resistance at 23°C, generally less than 50 ohm, preferably less than 15 ohm, more preferably less than 10 ohm, particularly less than 5 ohm, especially less than 3 ohm. Particularly suitable foil electrodes are microrough metal foil electrodes, including in particular electrodeposited nickel foils and nickel-plated electrodeposited copper foil electrodes, in particular as disclosed in U.S. Patents Nos. 4,689,475 and 4,800,253. A variety of laminar devices which can be modified in accordance with the present invention are disclosed in U.S. Patent Nos. 4,238,812, 4,255,798, 4,272,471, 4,315,237, 4,317,027, 4,330,703, 4,426,633, 4,475,138, 4,724,417, 4,780,598, 4,845,838, 4,907,340, and 4,924,074. The electrodes can be modified so as to produce desired thermal effects.

### Apertures and Cross-Conductors

The term "aperture" is used herein to denote an opening which
(a) has a closed cross section, e.g. a circle, an oval, or a generally rectangular shape, or
(b) has an open reentrant cross section which (i) has a depth at least 0.15 times, preferably at least 0.5 times, particularly at least 1.2 times, the maximum width of the cross section, e.g. a quarter circle or a half circle or an open-ended slot, and/or (ii) has at least one part where the opposite edges of the cross section are parallel to each other.
In assemblies of the invention which can be divided into a plurality of electrical devices, the apertures will normally be of closed cross section, but if one or more of the lines of division passes through an aperture of closed cross section, then the apertures in the resulting devices will then have open cross sections. It is important that any such open cross section is a reentrant cross section as defined above, in order to ensure that the cross-conductor is not damaged or dislodged during installation or use of the device.

The aperture can be a circular hole, and for many purposes this is satisfactory in both individual devices and assemblies of devices. However, if the assembly includes apertures which are traversed by at least one line of division, elongate apertures may be preferred because they require less accuracy in the lines of division.

When the aperture is not traversed by a line of division, it can be as small as is convenient for a cross-conductor having the necessary current-carrying capacity. For circuit protection devices, holes of diameter 0.1 to 5 mm, preferably 0.15 to 1.0 mm, e.g. 0.2 to 0.5 mm, are generally satisfactory. Generally a single cross-conductor is all that is needed to make an electrical connection to the first electrode from the opposite side of the device. However, two or more cross-conductors can be used to make the same connection. The number and size of the cross-conductors, and, therefore, their thermal capacity, can have an appreciable influence on the rate at which a circuit protection device will trip.

The aperture can be formed before the cross-conductor is put in place, or the formation of the aperture and the placing of the cross-conductor can be carried out simultaneously. A preferred procedure is to form the aperture, e.g. by drilling, slicing or any other appropriate technique, and then to plate or otherwise coat or fill the interior surface of the aperture. The plating can be effected by electroless plating, or electrolytic plating, or by a combination of both. The plating can be a single layer or multiple layers, and can be composed of a single metal or a mixture of metals, in particular a solder. The plating will often also be formed on other exposed conductive surfaces of the assembly. If such plating is not desired, then the other exposed conductive surfaces must be masked or otherwise desensitized. Generally, however, the plating is carried out at a stage of the process at which such additional plating will not produce an adverse effect. The invention includes the possibility that the plating will produce not only the cross-conductor but also at least part of the laminar conductive members in the device.

The plating techniques which are used for making conductive vias through insulating circuit boards can be used in the present invention. However, in this invention the plating serves merely to convey current across the device, whereas a plated via must make good electrical contact with another component. Consequently, the plating quality required in this invention may be less than that required for a via.

Another technique for providing the cross-conductors is to place a moldable or liquid conductive composition in preformed apertures, and if desired or necessary to treat the composition, while it is in the apertures, so as to produce cross-conductors of desired properties. The composition can be supplied selectively to the apertures, e.g. by means of a screen, or to the whole assembly, if desired after pretreating at least some of the assembly so that the composition does not stick to it. For example, a molten conductive composition, e.g. solder, could be used in this way, if desired using wave soldering techniques; and apertures in a PTC ceramic element could be filled with a conductive ceramic paste which was fired or otherwise consolidated in situ.

The cross-conductor can also be provided by a preformed member, e.g. a metal rod or tube, for example a rivet. When such a preformed member is used, it can create the aperture as it is put in place in the device.

The cross-conductor can partially or completely fill the aperture. When the aperture is partially filled, it can be further filled (including completely filled) during the process in which the device is connected to other electrical components, particularly by a soldering process. This can be encouraged by providing additional solder in and around the aperture, especially by including a plating of solder in and around the aperture. Normally at least a part of the cross-conductor will be put in place before the device is connected to other electrical components. However, the invention includes the possibility that the cross-conductor is formed during such a connection process, as for example by the capillary action of solder during a soldering process.

### Assemblies

As briefly noted above, the assemblies of the invention include both devices which are ready for connection to other electrical components and structures which (if necessary after further processing) can be divided into a plurality of electrical devices.

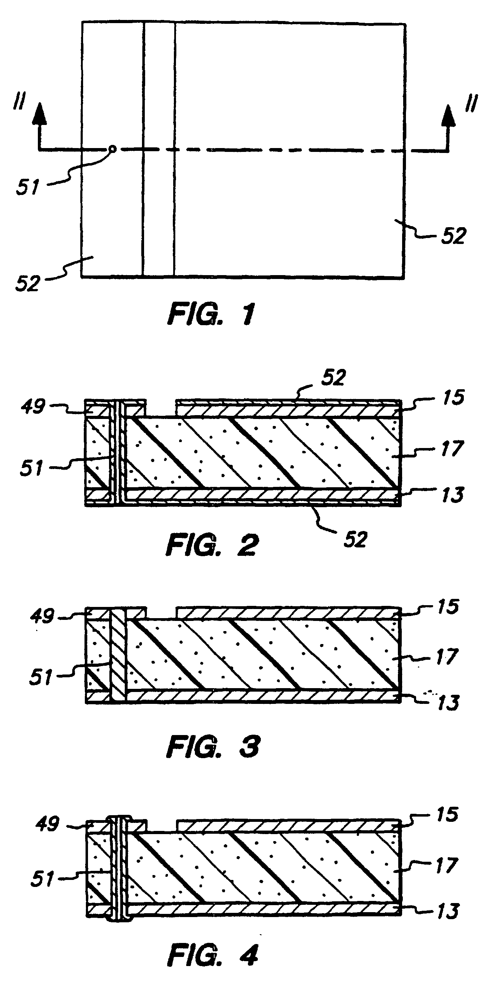

In the devices which are ready for connection, the "first laminar conductive member" (to which the cross-conductor is physically and electrically connected) provides the first electrode, and the device generally also includes a second laminar conductive member which is not connected to the first electrode or the cross-conductor and which provides the second electrode. The first and second electrodes are generally secured, directly or indirectly, to opposite faces of a laminar PTC element, and the current-carrying part of the PTC element is that part which lies between the two electrodes. Preferably the device also includes a third laminar conductive member which (a) is secured to the second face of the PTC element in the area of the aperture, (b) is electrically connected to the cross-conductor, and (c) is spaced apart from the second electrode. Thus this third member provides a conductive pad through which connection can be made to the first electrode (via the cross-conductor) and which is easier to make a connection to than the cross-conductor alone. This third member is preferably a residual member formed by removing a part of a laminar conductive member, in particular from one laminar conductive member of an assembly comprising two laminar conductive members and a PTC element between them; the other part of the conductive member provides the second electrode. The shape of the third member, and of the gap between the third member and the second electrode, can be varied to suit the desired characteristics of the device and for ease of manufacture. Thus the third member is conveniently a small rectangle at one end of a rectangular device, separated from the second electrode by a rectangular gap, as shown for example in Figures 1 and 2; but other arrangements are possible. For example the third member can be an island separated from the second electrode by a gap of closed cross section. If two or more devices in parallel are needed, there can be two or more second electrodes on the second face of the PTC element, with a single first electrode which is on the first face of the PTC element and to which connection is made via the cross-conductor. When two or more devices in series are required, the third member of one device can be connected to the second electrode of the adjacent device; the devices can be joined together by non-current-carrying sections of the PTC conductive polymer element, or otherwise.

In the simplest devices, there is a single first electrode, a single cross-conductor, a single third member, and a single second electrode. Such a device is illustrated in Figures 1 and 2. A disadvantage of such a device is that it must be placed on the circuit board the right way up. This disadvantage can be overcome (at the expense of additional material and processing costs) by making a device which has two third members (one associated with each electrode) and two cross-conductors (one associated with each third member). Such a device is illustrated in Figures 5 and 6.

A particularly preferred embodiment of this invention is a circuit protection device which has a resistance of less than 15 ohm, preferably less than 10 ohm, particularly less than 5 ohm, especially less than 1 ohm, and which comprises
(1) a laminar PTC resistive element which
   (a) is composed of a conductive polymer which has a resistivity at 25°C of less than 50 ohm-cm, preferably less than 10 ohm-cm, particularly less than 5 ohm-cm, and which exhibits PTC behavior, and
   (b) has a first face and second face;
(2) a first metal foil electrode which contacts the first face of the PTC element;
(3) a second metal foil electrode which contacts the second face of the PTC element; and
(4) an additional metal foil conductive member which contacts the second face of the PTC element and is spaced apart from the second electrode;
   the PTC element, the first electrode and the additional conductive member defining an aperture which runs between the first electrode and the additional conductive member, through the PTC element;
   and
(5) a transverse conductive member which
   (a) is composed of metal,
   (b) lies within the aperture, and
   (c) is physically and electrically connected to the first electrode and the additional conductive member.

The devices of the invention which are ready for connection can be of any appropriate size. However, it is an important advantage of the invention that very small devices can be easily prepared. Preferred devices of the invention have a maximum dimension of at most 12 mm, preferably at most 7 mm, and/or a surface area of at most 30 mm², preferably at most 20 mm², especially at most 15 mm².

In the assemblies of the invention which, if necessary after further processing, can be divided into a plurality of devices, preferably
(a) the PTC resistive element defines a plurality of the apertures running between the first and second faces of the PTC element,
(b) there are a plurality of the transverse conductive members, each of the transverse members lying within one of the apertures, and
(c) the apertures and the transverse members are arranged in a regular pattern.
Generally the assembly further comprises
(3) a first laminar conductive member which (a) is secured to the first face of the PTC element, and (b) is physically and electrically connected to all the transverse members; and
(4) a second laminar conductive member which is secured to the second face of the PTC element.
The transverse members can also be physically and electrically connected to a second laminar conductive member. The first and/or second conductive members, before the assembly is divided and before or after the transverse members are put in place, are preferably in the form of a plurality of strips, arranged so that the assembly can be divided, along lines parallel to the strips, into devices which comprise first and second electrodes and a third member which is on the same face of the PTC element as the second electrode but is not connected to the second electrode.

### Processes

The devices of the invention can be prepared in any way. However, the preferred methods of the invention make it possible to prepare devices very economically by carrying out all or most of the process steps on a large laminate, and then dividing the laminate into a plurality of individual devices, or into relatively small groups of devices which are connected together physically and which may be connected to each other electrically, in series or in parallel or both. The division of the laminate can be carried out along lines which pass through one or both or neither of the laminar conductive members or through none, some or all of the cross-conductors. The process steps prior to division can in general be carried out in any convenient sequence.

The invention is illustrated in the accompanying drawings, in which the size of the apertures and the thicknesses of the components have been exaggerated in the interests of clarity. Figure 1 is a plan view of a circuit protection device of the invention, and Figure 2 is a cross section on line II-II of Figure 1. The device includes a laminar PTC element 17 having a first face to which first laminar electrode 13 is attached and a second face to which second laminar electrode 15 is attached. Also attached to the second face is an additional laminar conductive member 49 which is not electrically connected to electrode 15. Cross-conductor 51 lies within an aperture defined by first electrode 13, PTC element 17 and additional member 49. The cross-conductor is a hollow tube formed by a plating process which also results in a plating 52 on the surfaces of the device which were exposed during the plating process.

Figures 3 and 4 are similar to Figure 2 but show cross-conductors which are in the form of a metal rod (Figure 3) or a rivet (Figure 4) .

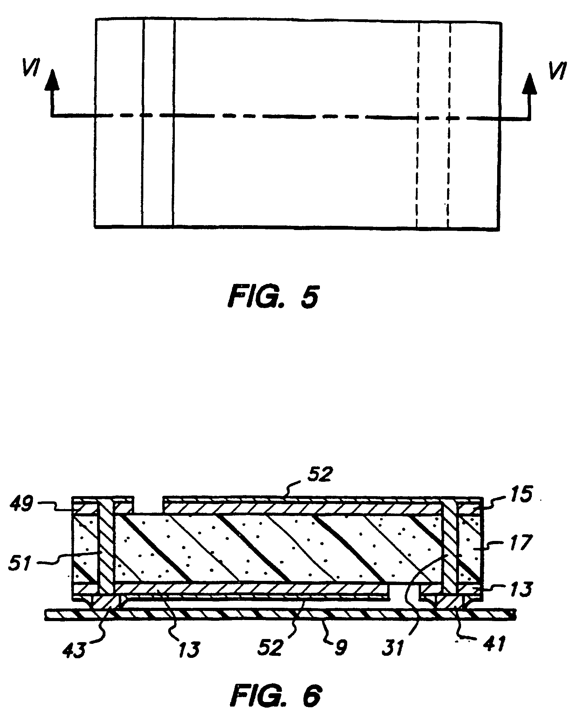

Figure 5 is a plan view of another circuit protection device of the invention which has been soldered to a circuit board, and Figure 6 is a cross section on line VI-VI of Figure 5. The device is similar to that shown in Figures 1 and 2 but has been made symmetrical so that it can be placed on a circuit board either way up. Thus the device includes a second cross-conductor 31 which connects the second electrode 15 to a second additional member 35. The cross-conductors were made by plating the apertures (and the other exposed surfaces) first with copper and then with solder. The device has been soldered to traces 41 and 43 on an insulating substrate 9. During the soldering process the solder plating on the device flows and completely fills the apertures.

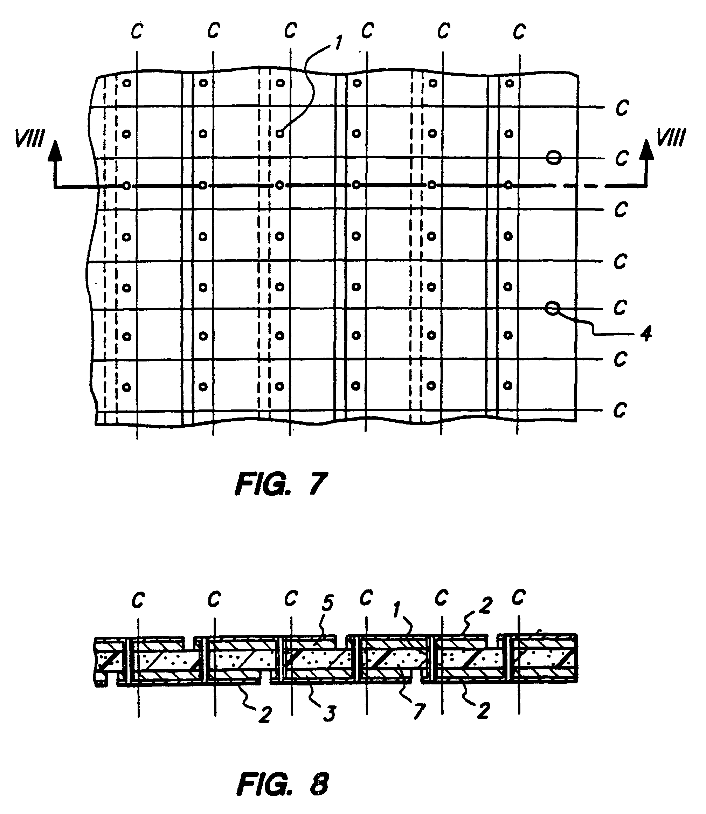

Figure 7 is a plan view of a part of an assembly of the invention which can be divided into a number of individual devices as shown in Figures 1 and 2, and Figure 8 is a cross section on line VIII-VIII of Figure 7. The assembly includes a laminar PTC element 7 having a first face to which first laminar conductive member 3 is attached and a second face to which second laminar conductive member 5 is attached. The conductive members 3 and 5 are not continuous but are in the form of parallel strips formed by removing, e.g. by etching, strips of electrode material from a corresponding continuous member. The material is removed in staggered strips alternately from opposite sides of the assembly, in order to balance the physical stresses in the product. Before the etching step, a plurality of holes, arranged in a regular pattern, have been drilled through the PTC element 7 and the laminar members 3 and 5, and the assembly has then been plated to provide a tubular cross-conductor 1 in each of the apertures (and a plating 2 on other exposed surfaces of the assembly). The assembly can be converted into a plurality of devices by dividing it along the lines marked C. At the edge of the assembly, there are registration holes 4 for use in locating the holes to be drilled through the element 7 and members 3 and 5, and in locating the lines of division C.

The invention is illustrated by the following Example.

### Example

A conductive polymer composition was prepared by pre blending 48.6% by weight high density polyethylene (Petrothene™ LB 832, available from USI) with 51.4% by weight carbon black (Raven™ 430, available from Columbian Chemicals), mixing the blend in a Banbury™ mixer, extruding the mixed compound into pellets, and extruding the pellets though a 3.8 cm (1.5 inch) extruder to produce a sheet with a thickness of 0.25 mm (0.010 inch). The extruded sheet was cut into 0.31 x 0.41 meter (12 x 16 inches) pieces and each piece was stacked between two sheets of 0.025 mm (0.001 inch) thick electrodeposited nickel foil (available from Fukuda). The layers were laminated under heat and pressure to form a plaque with a thickness of about 0.25 mm (0.010 inch). Each plaque was irradiated to 10 Mrad. Each plaque was used to prepare approximately 7000 devices, each having the configuration shown in Figures 1 and 2.

Holes with a diameter of 0.25 mm (0.010 inch) were drilled through the thickness of the plaque in a regular pattern to provide one hole for each device. Each hole was deburred and cleaned. The surface of both the nickel foil layers and the conductive polymer surrounding the drilled hole were sensitized using a palladium/copper solution. A copper layer approximately 0.076 mm (0.003 inch) thick was electroless plated onto the sensitized surfaces and then a 0.025 mm (0.001 inch) thick layer of tin-lead solder was electroless plated onto the copper surface. Using the following standard photoresist process, a pattern was etched onto the plaque. First, a dry film (Mylar™ polyester) resist was laminated onto both surfaces of the plaque and then exposed to ultraviolet light to generate a pattern as shown in Figures 7 and 8. Second, a ferric chloride solution was used to chemically etch the pattern. During this step, alternating sections on each side of the plaque were etched away to expose the solder and relieve built-up mechanical stress. Third, the etched plaque was rinsed and the resist was stripped away.

The plaque was sheared and diced to produce individual rectangular electrical devices. Each device had dimensions of 4.57 x 3.05 x 0.51 mm (0.180 x 0.120 x 0.020 inch). The through-hole was positioned approximately 3.81 mm (0.015 inch) from the shorter edge of the device. A strip of exposed conductive polymer 0.51 x 3.05 mm (0.020 x 0.120 inch) was present 0.38 mm (0.015 inch) from the through-hole and 1.02 mm (0.040 inch) from the shorter edge of the device. Each device had a resistance of approximately 300 mohm.

## Claims

1. An electrical assembly which (i) is a circuit protection device and (ii) comprises
(1) a laminar PTC resistive element (17) which (a) is composed of a conductive polymer which exhibits PTC behavior, (b) has a first face and a second face, and (c) defines an aperture which runs between the first and second faces;
(2) a transverse conductive member (51) which (a) lies within the aperture defined by the PTC element, (b) runs between the first and second faces of the PTC element, and (c) is secured to the PTC element;
(3) a first laminar conductive member (13) which (a) is secured to the first face of the PTC element and (b) is physically and electrically connected to the transverse conductive member;
(4) a second laminar conductive member (15) which is secured to the second face of the PTC element and which is not electrically connected to the transverse conductive member, and
(5) a third laminar conductive member (49) which (a) is secured to the second face of the PTC element in the area of the aperture, (b) is electrically connected to the transverse conductive member (51), and (c) is spaced apart from the second laminar conductive member.

2. An assembly according to claim 1 wherein the transverse conductive member (51) comprises at least one of
(a) a plating of metal on the surface of the PTC element which defines the aperture,
(b) solder, and
(c) a preformed metal rod or tube.

3. An assembly according to claim 1 in a structure which can be divided into a plurality of the said circuit protection devices, wherein
(a) the PTC resistive element (7) defines a plurality of apertures running between the first and second faces of the PTC element,
(b) there are a plurality of the transverse conductive members (1), each of the transverse members lying within one of the apertures, and
(c) the apertures and the transverse members are arranged in a regular pattern.

4. An assembly according to Claim 3 wherein the first laminar conductive member (3) is physically and electrically connected to all the transverse members (1).

5. An assembly according to Claim 4 wherein each of the first and second laminar conductive members consists of a plurality of parallel strips.

6. An electrical assembly which comprises
(A) a printed circuit board (9) including first and second conductive traces (41,43) on a surface thereof, and
(B) an electrical device which comprises
(1) a laminar PTC resistive element (17) which (a) is composed of a resistive material which exhibits PTC behavior, and (b) has a first face and a second face;
(2) a first laminar electrode (13) which is secured to the first face of the PTC element;
(3) a second laminar electrode (15) which is secured to the second face of the PTC element;
(4) an additional laminar conductive member (49) which (a) is secured to the second face of the PTC element and (b)is spaced apart from the second electrode;
the PTC element, the first electrode and the additional laminar conductive member defining an aperture which runs between the first electrode and the additional conductive member, through the PTC element; and
(5) a transverse conductive-member (51) which
(a) lies within the aperture, and
(b) is physically and electrically connected to the first electrode and the additional conductive member;
said electrical device being placed on the printed circuit board and parallel thereto, with the first conductive trace physically and electrically connected to the additional conductive member, and the second conductive trace physically and electrically connected to the second electrode.

7. A method of making an electrical device according to Claim 1 which comprises
(A) providing an assembly which comprises
(1) a laminar PTC resistive element (7) which (i) is composed of a resistive material exhibiting PTC behavior, and (ii) has a first face and a second face,
(2) a first laminar conductive member (3) which is secured to the first face of the PTC element, and
(3) a second laminar conductive member (5) which is secured to the second face of the PTC element;
(B) making a plurality of apertures through the thickness of the assembly provided in step (A), the apertures being arranged in a regular pattern;
(C) simultaneously with step (B), or after step (B), placing a plurality of transverse conductive members (1) within the apertures, in electrical contact with the first laminar conductive member;
(D) removing predetermined portions of at least one of the first and second conductive members; and
(E) after steps (A) to (D), dividing the assembly into a plurality of electrical devices, each device comprising
(1) a part of the PTC resistive element,
(2) a part of the first laminar conductive member, said part providing a first electrode in some of the devices and a second electrode in the other devices,
(3) a part of the second laminar conductive member, said part providing a second electrode in some of the devices and a first electrode in the other devices,
(4) a residual part of the second laminar conductive member, and
(5) at least one transverse conductive member which electrically connects the residual part and the first electrode.

8. A multi-device assembly which comprises
(1) a laminar PTC resistive element (7) which (i) is composed of a conductive polymer exhibiting PTC behavior, and (ii) has a first face and a second face,
(2) a first laminar conductive member (3) which is secured to the first face of the PTC element, and
(3) a second laminar conductive member (5) which is secured to the second face of the PTC element;
the PTC element and the first and second laminar conductive members defining a plurality of apertures which pass through the thickness of the assembly, and the apertures being arranged in a regular pattern, **characterised in that** the first and second laminar conductive members are in the form of discontinuous parallel strips and the strips of the first conductive member (3) are staggered in relation to the strips of the second conductive member (5) so that the multi-device assembly can be divided into a plurality of assemblies which are circuit protection devices according to any of claims 1 to 6.

## Patentansprüche

1. Elektrische Anordnung, die (I) ein Schaltungsschutzgerät ist und (II) folgendes aufweist:
(1) eine laminares PTC-Element (17), das (a) aus einem leitfähigen Polymer mit PTC-Verhalten besteht, (b) eine erste Fläche und eine zweite Fläche hat und (c) eine Öffnung definiert, die zwischen der ersten und zweiten Fläche verläuft;
(2) ein leitfähiges Querelement (51), das (a) in der durch das PTC-Element definierten Öffnung liegt, (b) zwischen der ersten und zweiten Fläche des PTC-Elements verläuft und (c) am PTC-Element befestigt ist;
(3) ein erstes laminares leitfähiges Element (13), das (a) an der ersten Fläche des PTC-Elements befestigt ist und (b) physikalisch und elektrisch mit dem leitfähigen Querelement verbunden ist;
(4) ein zweites laminares leitfähiges Element (15), das an der zweiten Fläche des PTC-Elements befestigt ist und das nicht elektrisch mit dem leitfähigen Querelement verbunden ist; und
(5) ein drittes laminares leitfähiges Element (49), das (a) an der zweiten Fläche des PTC-Elements im Bereich der Öffnung befestigt ist, (b) elektrisch mit dem leitfähigen Querelement (51) verbunden ist und (c) vom zweiten laminaren leitfähigen Element beabstandet ist.

2. Anordnung nach Anspruch 1, bei der das leitfähige Querelement (51) mindestens eine der folgenden Positionen aufweist:
(a) eine Metallplattierung auf der Oberfläche des PTC-Elements, das die Öffnung definiert,
(b) Lot und
(c) einen vorgeformten Metallstab oder ein Rohr.

3. Anordnung nach Anspruch 1 in einer Struktur, die in eine Vielzahl der Schaltungsschutzgeräte geteilt werden kann, bei der
(a) das PTC-Widerstandselement (7) eine Vielzahl Öffnungen definiert, die zwischen der ersten und zweiten Fläche des PTC-Elements verlaufen,
(b) eine Vielzahl der leitfähigen Querelemente (1) vorgesehen ist, wobei jedes der Querelemente in einer der Öffnungen liegt, und
(c) die Öffnungen und die Querelemente in einem regelmäßigen Muster angeordnet sind.

4. Anordnung nach Anspruch 3, bei der das erste laminare leitfähige Element (3) mit sämtlichen Querelementen (1) physikalisch und elektrisch verbunden ist.

5. Anordnung nach Anspruch 4, bei der jedes der ersten und zweiten laminaren leitfähigen Elemente aus einer Vielzahl paralleler Streifen besteht.

6. Elektrische Anordnung, die folgendes aufweist:
(A) eine Platine (9) mit ersten und zweiten Leiterbahnen (41, 43) auf einer Oberfläche derselben und
(B) ein elektrisches Gerät, welches folgendes aufweist:
(1) ein laminares PTC-Widerstandselement (17), das (a) aus einem ohmschen Material mit PTC-Verhalten besteht und (b) eine erste und eine zweite Fläche hat;
(2) eine erste laminare Elektrode (13), die an der ersten Fläche des PTC-Elements befestigt ist;
(3) eine zweite laminare Elektrode (15), die an der zweiten Fläche des PTC-Elements befestigt ist;
(4) ein zusätzliches laminares leitfähigen Element (49), das (a) an der zweiten Fläche des PTC-Elements befestigt und (b) von der zweiten Elektrode beabstandet ist;
wobei das PTC-Element, die erste Elektrode und das zusätzliche laminare leitfähige Element eine Öffnung begrenzen, die zwischen der ersten Elektrode und dem zusätzlichen leitfähigen Element durch das PTC-Element verläuft; und
(5) ein leitfähiges Querelement (51), das
(a) in der Öffnung liegt und
(b) physikalisch und elektrisch mit der ersten Elektrode und dem zusätzlichen leitfähigen Element verbunden ist;
wobei das elektrische Gerät auf der Platine und parallel zu dieser angeordnet ist, so dass die erste Leiterbahn physikalisch und elektrisch mit dem zusätzlichen leitfähigen Element und die zweite Leiterbahn physikalisch und elektrisch mit der zweiten Elektrode verbunden ist.

7. Verfahren zur Herstellung eines elektrischen Geräts nach Anspruch 1, das die folgenden Schritte aufweist:
(A) Bereitstellen einer Anordnung, die folgendes aufweist:
(1) ein laminares PTC-Widerstandselement (7), das (I) aus einem ohmschen Material mit PTC-Verhalten besteht und (II) eine erste und eine zweite Fläche hat;
(2) ein erstes laminares leitfähiges Element (3), das an der ersten Fläche des PTC-Elements befestigt ist;
(3) ein zweites laminares leitfähiges Element (5), das an der zweiten Fläche des PTC-Elements befestigt ist;
(B) Herstellen einer Vielzahl von Öffnungen durch die Dicke der in Schritt (A) bereitgestellten Anordnung, wobei die Öffnungen in einem regelmäßigen Muster angeordnet sind;
(C) gleichzeitig mit Schritt (B) oder nach Schritt (B) Einsetzen einer Vielzahl leitfähiger Querelemente (1) in die Öffnungen, die in elektrischem Kontakt mit dem ersten laminaren leitfähigen Element stehen;
(D) Entfernen vorgegebener Abschnitte von mindestens einem der ersten und zweiten leitfähigen Elemente; und
(E) nach Schritten (A) bis (D) Teilen der Anordnung in eine Vielzahl elektrischer Geräte, wobei jedes Geräte folgendes aufweist:
(1) einen Teil des PTC-Widerstandselements,
(2) einen Teil des ersten laminaren leitfähigen Elements, wobei dieser Teil bei manchen der Geräte eine erste Elektrode und bei den anderen Geräten eine zweite Elektrode bereitstellt,
(3) einen Teil des zweiten laminaren leitfähigen Elements, wobei dieser Teil bei manchen der Geräte eine zweite Elektrode und den anderen Geräten eine erste Elektrode bereitstellt,
(4) einen restlichen Teil des zweiten laminaren leitfähigen Elements und
(5) mindestens ein leitfähiges Querelement, das den restlichen Teil und die erste Elektrode elektrisch verbindet.

8. Aus mehreren Geräten bestehende Anordnung, die folgendes aufweist:
(1) ein laminares PTC-Widerstandselement (7), das (I) aus einem leitfähigen Polymer mit PTC-Verhalten besteht und (II) eine erste Fläche und eine zweite Fläche hat,
(2) ein erstes laminares leitfähiges Element (3), das an der ersten Fläche des PTC-Elements befestigt ist, und
(3) ein zweites laminares leitfähiges Element (5), das an der zweiten Fläche des PTC-Elements befestigt ist,
wobei das PTC-Element und die ersten und zweiten laminaren leitfähigen Elemente eine Vielzahl von Öffnungen definieren, die durch die Dicke der Anordnung verlaufen, und die Öffnungen in einem regelmäßigen Muster angeordnet sind, **dadurch gekennzeichnet, dass** die ersten und zweiten laminaren leitfähigen Elemente in Form unterbrochener paralleler Streifen vorhanden sind und die Streifen des ersten leitfähigen Elements (3) gegenüber den Streifen des zweiten leitfähigen Elements (5) versetzt sind, so dass die aus mehreren Geräten bestehende Anordnung in eine Vielzahl von Anordnungen geteilt werden kann, bei denen es sich um Schaltungsschutzgeräte nach einem der Ansprüche 1 bis 6 handelt.

## Revendications

1. Ensemble électrique qui (i) est un dispositif de protection de circuit et (ii) comporte
(1) un élément résistif CTP lamellaire (17) qui (a) est composé d'un polymère conducteur qui présente un comportement CTP, (b) a une première face et une seconde face, et (c) définit une ouverture qui s'étend entre les première et seconde faces ;
(2) un élément conducteur transversal (51) qui (a) s'étend à l'intérieur de l'ouverture définie par l'élément CTP, (b) s'étend entre les première et seconde faces de l'élément CTP et, (c) est fixé à l'élément CTP ;
(3) un premier élément conducteur lamellaire (13) qui (a) est fixé à la première face de l'élément CTP et (b) est connecté physiquement et électriquement à l'élément conducteur transversal ;
(4) un deuxième élément conducteur lamellaire (15) qui est fixé à la seconde face de l'élément CTP et qui n'est pas connecté électriquement à l'élément conducteur transversal ; et
(5) un troisième élément conducteur lamellaire (49) qui (a) est fixé à la seconde face de l'élément CTP dans la zone de l'ouverture, (b) est connecté électriquement à l'élément conducteur transversal (51), et (c) est espacé du deuxième élément conducteur lamellaire.

2. Ensemble selon la revendication 1, dans lequel l'élément conducteur transversal (51) comporte au moins l'un de
(a) un plaquage de métal sur la surface de l'élément CTP qui définit l'ouverture,
(b) une soudure, et
(c) une tige ou un tube métallique préformé.

3. Ensemble selon la revendication 1 dans une structure qui peut être divisée en une pluralité desdits dispositifs de protection de circuits, dans lequel
(a) l'élément résistif CTP (7) définit une pluralité d'ouvertures s'étendant entre les première et seconde faces de l'élément CTP,
(b) il y a une pluralité d'éléments conducteurs transversaux (1), chacun des éléments transversaux s'étendant à l'intérieur de l'une des ouvertures, et
(c) les ouvertures et les éléments transversaux sont agencés en un motif régulier.

4. Ensemble selon la revendication 3, dans lequel le premier élément conducteur lamellaire (3) est connecté physiquement et électriquement à tous les éléments transversaux (1).

5. Ensemble selon la revendication 4, dans lequel chacun des premier et deuxième éléments conducteurs lamellaires consiste en une pluralité de bandes parallèles.

6. Ensemble électrique qui comporte
(A) une plaquette (9) à circuit imprimé comprenant des première et seconde pistes conductrices (41, 43) sur l'une de ses surfaces, et
(B) un dispositif électrique qui comporte
(1) un élément résistif CTP lamellaire (17) qui (a) est composé d'une matière résistive qui présente un comportement CTP, et (b) a une première face et une seconde face ;
(2) une première électrode lamellaire (13) qui est fixée à la première face de l'élément CTP ;
(3) une deuxième électrode lamellaire (15) qui est fixée à la seconde face de l'élément CTP ;
(4) un élément conducteur additionnel lamellaire (49) qui (a) est fixé à la seconde face de l'élément CTP et (b) est espacé de la seconde électrode ;
l'élément CTP, la première électrode et l'élément conducteur additionnel lamellaire définissant une ouverture qui s'étend entre la première électrode et l'élément conducteur additionnel, à travers l'élément CTP ; et
(5) un élément conducteur transversal (51) qui
(a) s'étend dans l'ouverture, et
(b) est connecté physiquement et électriquement à la première électrode et à l'élément conducteur additionnel ;
ledit dispositif électrique étant placé sur la plaquette à circuit imprimé et parallèlement à celle-ci, avec la première trace conductrice connectée physiquement et électriquement à l'élément conducteur additionnel, et la seconde trace conductrice connectée physiquement et électriquement à la seconde électrode.

7. Procédé de réalisation d'un dispositif électrique selon la revendication 1, qui comprend
(A) la production d'un ensemble qui comporte
(1) un élément résistif CTP lamellaire (7) qui (i) est composé d'une matière résistive présentant un comportement CTP, et (ii) a une première face et une seconde face,
(2) un premier élément conducteur lamellaire (3) qui est fixé à la première face de l'élément CTP, et
(3) un deuxième élément conducteur lamellaire (5) qui est fixé à la seconde face de l'élément CTP ;
(B) la réalisation d'une pluralité d'ouvertures à travers l'épaisseur de l'ensemble produit dans l'étape (A), les ouvertures étant agencées suivant un motif régulier ;
(C) simultanément à l'étape (B), ou après l'étape (B) , la mise en place d'une pluralité d'éléments conducteurs transversaux (1) à l'intérieur des ouvertures, en contact électrique avec le premier élément conducteur lamellaire ;
(D) l'enlèvement de parties prédéterminées d'au moins l'un des premier et deuxième éléments conducteurs ; et
(E) après les étapes (A) à (D), la division de l'ensemble en une pluralité de dispositifs électriques, chaque dispositif comportant
(1) une partie de l'élément résistif CTP,
(2) une partie du premier élément conducteur lamellaire, ladite partie fournissant une première électrode dans certains des dispositifs et une seconde électrode dans les autres dispositifs,
(3) une partie du deuxième élément conducteur lamellaire, ladite partie fournissant une seconde électrode dans certains des dispositifs et une première électrode dans les autres dispositifs,
(4) une partie résiduelle du deuxième élément conducteur lamellaire, et
(5) au moins un élément conducteur transversal qui connecte électriquement la partie résiduelle et la première électrode.

8. Ensemble de dispositifs multiples qui comporte
(1) un élément résistif CTP lamellaire (7) qui (i) est composé d'un polymère conducteur présentant un comportement CTP, et (ii) a une première face et une seconde face,
(2) un premier élément conducteur lamellaire (3) qui est fixé à la première face de l'élément CTP, et
(3) un second élément conducteur lamellaire (5) qui est fixé à la seconde face de l'élément CTP ;
l'élément CTP et les premier et second éléments conducteurs lamellaires définissant une pluralité d'ouvertures qui passent à travers l'épaisseur de l'ensemble, et les ouvertures étant agencées en un motif régulier, **caractérisé en ce que** les premier et second éléments conducteurs lamellaires se présentent sous la forme de bandes parallèles discontinues et les bandes du premier élément conducteur (3) sont décalées par rapport aux bandes du second élément conducteur (5) afin que l'ensemble de dispositifs multiples puisse être divisé en une pluralité d'ensembles qui sont des dispositifs de protection de circuits selon l'une quelconque des revendications 1 à 6.
